Europäisches Patentamt

European Patent Office

Office européen des brevets

(19)

(11) Veröffentlichungsnummer: **0 022 474**
**B1**

(12)

# EUROPÄISCHE PATENTSCHRIFT

(45) Veröffentlichungstag der Patentschrift:
12.01.83

(51) Int. Cl.³: **H 01 L 21/90**

(21) Anmeldenummer: 80103196.4

(22) Anmeldetag: 09.06.80

(54) Verfahren zum Herstellen von niederohmigen, diffundierten Bereichen bei der Silizium-Gate-Technologie.

(30) Priorität: 03.07.79 DE 2926874

(43) Veröffentlichungstag der Anmeldung:
21.01.81 Patentblatt 81/3

(45) Bekanntmachung des Hinweises auf die Patenterteilung:
12.01.83 Patentblatt 83/2

(84) Benannte Vertragsstaaten:
FR GB

(56) Entgegenhaltungen:
EP-A-0 000 317
DE-A-2 815 605
US-A-3 460 007
US-A-3 667 008
US-A-4 163 246
THE BELL SYSTEM TECHNICAL JOURNAL, Band 47, 1968 New York M.P. LEPSELTER et al. «Silicon Schottky Barrier Diode with Near-Ideal I–V Characteristics»
PROCEEDINGS ELECTROCHEMICAL SOC. SPRING MEETING, Mai 1978, Abstract Nr. 274 C.E. WEITZEL et al. «PtSi/Polysilicon Gate CMOS/SOS Transistors»

(73) Patentinhaber: SIEMENS AKTIENGESELLSCHAFT
Berlin und München, Postfach 22 02 61,
D-8000 München 22 (DE)

(72) Erfinder: Widmann, Dietrich, Dr.,
Ludwig-Steub-Strasse 2, D-8025 Unterhaching (DE)

Verfahren zum Herstellen von niederohmigen, diffundierten Bereichen bei der Silizium-Gate-Technologie

Die vorliegende Patentanmeldung betrifft ein Verfahren zum Herstellen von niederohmigen, als stromzuführende Bahnen in integrierten MOS-Halbleiterschaltungen zu verwendende, diffundierte Bereiche bei der Silizium-Gate-Technologie, wobei der Schichtwiderstand dieser Bereiche durch eine oberflächliche Metallsilizid-Bildung herabgesetzt wird.

In komplexen MOS-Schaltungen werden häufig, z.B. bei dynamischen RAM (random-access-memory)-Schaltungen die bei der Source-Drain-Dotierung entstehenden diffundierten Bereiche als stromzuführende Bahnen verwendet. Der Schichtwiderstand solcher Bereiche hat bei kleiner Eindringtiefe des Dotierstoffes von z.B. ca. 0,5 μm eine untere Grenze bei ca. 15 $\Omega/\square$. Dieser Wert kann für den beanspruchten Zweck zu hoch sein; gewünscht werden in manchen Fällen nur wenige $\Omega/\square$.

Aus dem Bell System Techn. Journal 47 (1968) S. 195–208 (Lepselter) ist bekannt, Silizium-Schottky-Barrier-Dioden mit Platinsilizid-Kontakten und diffundierten Schutzringen herzustellen und dadurch die Schaltgeschwindigkeiten dieser Dioden wesentlich zu erhöhen.

Diese Platinsilizid-Technologie wird in einem Aufsatz von C.E. Weitzel und D.J. Tanguay in Proceedings Electrochem. Soc. Spring Meeting (Mai 1978) auf den Seiten 683 bis 685 für die Herstellung von Platinsilizid/Polysilizium-Gate-MOS-Transistoren benutzt, um den Schichtwiderstand von dotierten, polykristallinen Bereichen durch eine oberflächliche Platinsilizidbildung um etwa eine Grössenordnung herabzusetzen. Will man entsprechend eine solche Silizidschicht auch auf den einkristallinen diffundierten Bereichen erzeugen, so bereitet dies beim Silizium-Gate-Prozess insofern Schwierigkeiten, weil dabei Kurzschlüsse zwischen den einkristallinen diffundierten Bereichen und den polykristallinen Gate-Elektrodenbereichen entstehen können, die nur ca. 50 nm (dies entspricht der Gateoxiddicke) voneinander entfernt sind. Aus der EU-A-0 000 317 ist ein Verfahren gemäss dem ersten Teil des Anspruchs 1 bekannt, bei dem eine Metallsilizidschicht mit Hilfe einer unter ihr befindlichen Fotoresistmaske (Lift-Off-Technik) so strukturiert wird, dass die diffundierten Bereiche von der Metallsilizidschicht bedeckt bleiben, und bei dem anschliessend die Gateoxidation durchgeführt wird.

Die Aufgabe, die der Erfindung zugrundeliegt, besteht deshalb darin, ein MOS-Verfahren anzugeben, bei dem solche Kurzschlüsse nicht auftreten können und bei dem trotzdem Schichtwiderstände der diffundierten Bereiche erzielt werden können, die im Bereich von wenigen $\Omega/\square$ liegen.

Diese Aufgabe wird bei einem Verfahren der eingangs genannten Art dadurch gelöst, dass die auf einer dotierten Polysiliziumschicht vor der Gateoxidation erzeugten Metallsilizidschicht mit Hilfe einer auf die Metallsilizidschicht aufgebrachten Siliziumoxidschicht so strukturiert wird, dass die diffundierten Bereiche von der entstandenen Dreifachschicht (SiO$_2$-Metallsilizid-Polysilizium) bedeckt bleiben und dass anschliessend die Gateoxidation durchgeführt wird.

Dabei liegt es im Rahmen des Erfindungsgedankens, folgende Verfahrensschritte nacheinander durchzuführen:

a) Abscheidung einer polykristallinen Siliziumschicht eines zweiten Leitungstyps auf einem einkristallinen Siliziumsubstrat eines ersten Leitungstyps,

b) Abscheidung einer die Silizide bildenden Metallschicht und Überführung der oberflächennahen Zone der polykristallinen Siliziumschicht in eine Metallsilizidschicht,

c) ganzflächige Abscheidung einer Siliziumdioxidschicht,

d) Strukturierung der Dreifachschicht: SiO$_2$-Metallsilizid-polykristalline Siliziumschicht so, dass die diffundierten, einkristallinen Bereiche bedeckt bleiben,

e) Herstellung des Gateoxids durch thermische Oxidation,

f) Ätzung von Kontaktlöchern zu den diffundierten Bereichen,

g) ganzflächige Abscheidung einer undotierten polykristallinen Siliziumschicht,

h) lokale Oxidation der undotierten Polysiliziumschicht unter Verwendung einer Nitridmaske mit Ausnahme der Gatebereiche und der Kontaktlöcher zu den diffundierten Bereichen,

i) Dotierung der undotierten Polysiliziumschicht mit einem Dotierstoff des zweiten Leitungstyps,

j) Erzeugung der metallischen Leitbahnen.

Weitere Ausgestaltungen der Erfindung sind aus den Unteransprüchen zu entnehmen.

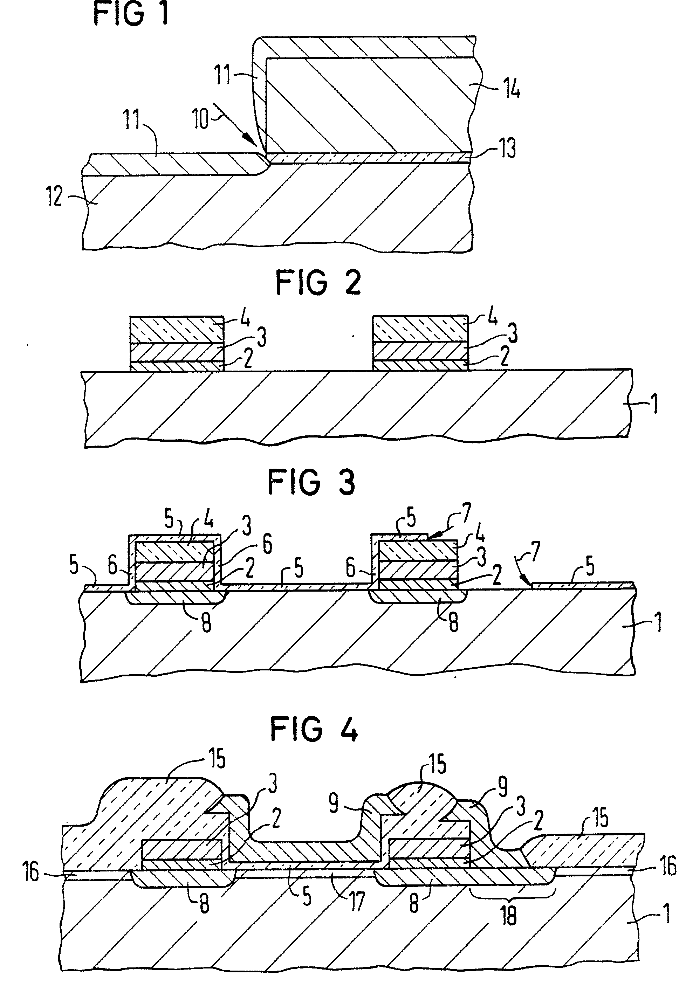

Anhand eines Ausführungsbeispiels und der Figuren 2 bis 4, welche die beim Prozess in den verschiedenen Stadien entstehenden Strukturen schematisch darstellen, wird im folgenden das Verfahren nach der Lehre der Erfindung noch näher erläutert. Die Figur 1 zeigt im Schnittbild einen Ausschnitt eines nach dem herkömmlichen Silizium-Gate-Prozess unter Verwendung von Metallsiliziden hergestellten Transistors. Wie aus der Figur 1 zu entnehmen ist, besteht an der mit dem Pfeil 10 gekennzeichneten Stelle durch die gebildete Metallsilizidschicht 11 Kurzschlussgefahr zwischen dem einkristallinen Siliziumbereich 12 und der auf dem Gateoxid 13 abgeschiedenen Polysiliziumschicht 14.

Zur Vermeidung dieser Kurzschlussgefahr wird erfindungsgemäss folgender, durch nur vier Maskierungsschritte gekennzeichneter n-Kanal-MOS-Herstellprozess vorgeschlagen:

Figur 2: Auf einer p-dotierten einkristallinen Siliziumsubstratscheibe 1 wird ganzflächig eine n-dotierte polykristalline Siliziumschicht 2 von 0,2 μm Dicke und einem spezifischen Widerstand von 200 $\Omega/\square$ durch ein CVD-Verfahren (chemical-vapour-deposition) niedergeschlagen. Dann wird darauf durch Aufdampfen oder Aufstäuben eine aus Platin, Wolfram oder Molybdän bestehende Metallschicht (3) in ca. 0,1 µm Dicke niedergeschlagen und durch Temperung in Inertgasatmosphäre bei 600° bis 800 °C in eine Metallsilizidschicht 3 mit einem Schichtwiderstand von nur wenigen $\Omega/\square$ übergeführt. Bei dieser Temperaturbehandlung werden etwa 0,1 µm der 0,2 µm dikken Polysiliziumschicht 2 in die Silizidschicht 3 übergeführt. Dann wird ganzflächig eine ca. 0,3 µm dicke $SiO_2$-Schicht 4 durch ein CVD-Verfahren niedergeschlagen. Diese Schichtenfolge (Polysilizium 2, Metallsilizidschicht 3 und $SiO_2$-Schicht 4) wird mittels einer Ätzmaske (1. Maske) so strukturiert, dass die Dreifachschicht dort erhalten bleibt, wo die einkristallinen, diffundierten Bereiche (8) gewünscht werden (siehe Figur 2).

Figur 3: die in Figur 2 dargestellte Anordnung wird einer thermischen Oxidation zur Gateoxidbildung unterworfen, wobei eine Gateoxidschicht 5 in einer Dicke von 20 bis 60 nm entsteht. Gleichzeitig wächst auch eine $SiO_2$-Schicht 6 an den Polysiliziumflanken 2 und an den Flanken der Silizidschicht 3. Ausserdem werden die n-dotierten Bereiche 8 erzeugt. Zur Kontaktlochätzung werden mittels einer Fotolackmaske (zweite Maske) an denjenigen Stellen Löcher (7) in das Gateoxid 5 geätzt, an denen Kontakte zu den diffundierten Bereichen (8) vorgesehen sind. Wie aus Figur 3 zu entnehmen ist, ragt ein Teil der Kontaktlochfläche (7) über den betreffenden diffundierten Bereich (8) über, ohne dass die ca. 0,3 µm dicke $SiO_2$-Schicht 4 dort ganz durchgeätzt zu werden braucht. Die Pfeile 7 zeigen die Ränder des Kontaktloches an.

Figur 4: Nach dem Abscheiden einer undotierten 0,1 µm bis 0,5 µm dicken Polysiliziumschicht 9 erfolgt die lokale Oxidation des Polysiliziums (9) mit Hilfe von z.B. Siliziumnitrid (dritte Maske, nicht dargestellt), wobei das Polysilizium 9 am Ort der Gatebereiche (5) und der Kontaktlöcher 7 zu den $n^+$-diffundierten Bereichen 8 stehen bleibt. An den übrigen Stellen wird das Polysilizium (9) in ganzer Dicke in eine $SiO_2$-Schicht 15 umgewandelt.

Nach der Nitridätzung, d.h. vor dem Entfernen der Lackmaske (dritte Maske) kann, falls erforderlich, Bor zur Einstellung der Feldoxid-Einsatzspannung implantiert werden, wodurch die Zonen 16 im Substrat 1 entstehen.

Falls erwünscht, kann auch durch Implantation einer entsprechenden Dosis von Fremdatomen, z.B. von Bor, Phosphor oder Arsen, durch Erzeugen einer Kanalzone 17 unter dem Gateoxid 5 die Einsatzspannung der Transistoren eingestellt werden. Abschliessend erfolgt die Dotierung des Polysiliziums 9 mit Phosphor oder Arsen, wodurch auch der unter dem Kontaktloch 7 liegende Teil 18 des $n^+$-diffundierten Bereichs 8 entsteht. Bei der Erzeugung der metallischen Leitbahnen (Maske 4) ist es nicht erforderlich, dass die Polysiliziuminseln 9 ganz von Metall bedeckt sind. Dieser Verfahrensschritt ist in den Figuren der besseren Übersicht wegen nicht mehr dargestellt.

## Patentansprüche

1. Verfahren zum Herstellen von niederohmigen, als stromzuführende Bahnen in integrierten MOS-Halbleiterschaltungen zu verwendenden diffundierten Bereichen (8) bei der Silizium-Gate-Technologie, wobei der Schichtwiderstand dieser Bereiche (8) durch eine oberfläche Metallsilizidschichtbildung (3) herabgesetzt wird, dadurch gekennzeichnet, dass die auf einer dotierten Polysiliziumschicht (2) vor der Gateoxidation (5) erzeugte Metallsilizidschicht (3) mit Hilfe einer auf die Metallsilizidschicht (3) aufgebrachten Siliziumdioxidschicht (4) so strukturiert wird, dass die diffundierten Bereiche (8) von der entstandenen Dreifachschicht bedeckt bleiben und dass anschliessend die Gateoxidation (5) durchgeführt wird.

2. Verfahren nach Anspruch 1, gekennzeichnet durch folgende Verfahrensschritte:

a) Abscheidung einer polykristallinen Siliziumschicht (2) eines zweiten Leitungstyps auf einem einkristallinen Siliziumsubstrat (1) eines ersten Leitungstyps,

b) Abscheidung einer die Silizide bildenden Metallschicht und Überführung der oberflächennahen Zone der polykristallinen Siliziumschicht in eine Metallsilizidschicht (3),

c) ganzflächige Abscheidung einer Siliziumdioxidschicht (4),

d) Strukturierung der Dreifachschicht $SiO_2$-Metallsilizid-polykristalline Siliziumschicht so, dass die diffundierten, einkristallinen Bereiche (8) bedeckt bleiben,

e) Herstellung des Gateoxids (5) durch thermische Oxidation,

f) Ätzung von Kontaktlöchern (7) zu den diffundierten Bereichen,

g) ganzflächige Abscheidung einer undotierten polykristallinen Siliziumschicht (9),

h) lokale Oxidation der undotierten Polysiliziumschicht (9) unter Verwendung einer Nitridmaske mit Ausnahme der Gatebereiche und der Kontaktlöcher zu den diffundierten Bereichen (8),

i) Dotierung der undotierten Polysiliziumschicht (9) mit einem Dotierstoff des zweiten Leitungstyps,

j) Erzeugung der metallischen Leitbahnen.

3. Verfahren nach Anspruch 1 und/oder 2, dadurch gekennzeichnet, dass die dotierte polykristalline Siliziumschicht (2) in einer Schichtdicke von ca. 0,2 µm abgeschieden wird.

4. Verfahren nach Anspruch 1 bis 3, dadurch gekennzeichnet, dass als silizidbildende Metallschicht eine Platin-, Wolfram- oder Molybdänschicht, vorzugsweise in einer Schichtdicke von ca. 0,1 µm, abgeschieden und in die Metallsilizidschicht (3) überführt wird.

5. Verfahren nach Anspruch 4, dadurch gekennzeichnet, dass die Silizidschichtbildung in Inertgasatmosphäre bei 600 bis 800 °C durchgeführt wird.

6. Verfahren nach Anspruch 1 bis 5, dadurch gekennzeichnet, dass die Schichtdicke der auf die Metallsilizidschicht (3) aufgebrachten $SiO_2$-

Schicht (4) auf einen Bereich von 0,2–0,5 μm, vorzugsweise auf 0,3 μm, eingestellt wird.

7. Verfahren nach Anspruch 1 bis 6, dadurch gekennzeichnet, dass die Gateoxiddicke (5) auf 20 bis 60 nm, eingestellt wird.

8. Verfahren nach Anspruch 1 bis 7, dadurch gekennzeichnet, dass nach der Ätzung der Nitridmaske zur Einstellung der Gateoxideinsatzspannung Dotierstoff des ersten Leitungstyps implantiert wird.

9. Verfahren nach Anspruch 1 bis 8, dadurch gekennzeichnet, dass zur Einstellung der Einsatzspannung der Transistoren vor dem Verfahrensschritt i) eine Implantation von vorzugsweise aus Bor, Phosphor oder Arsen bestehenden Fremdatomen durchgeführt wird.

**Revendications**

1. Procédé pour former des régions diffusées (8) à faible résistance ohmique destinées à être utilisée comme voies d'amenée de courant dans des circuits semiconducteurs MOS intégrés, dans la technologie des portes en silicium, la résistance de couches de ces régions (8) étant diminuée par une formation superficielle de couche de siliciures métalliques, caractérisé en ce que la couche (3) de siliciures métalliques produite avant l'oxydation de portes (5) sur une couche (2) de polysilicium dopée est structurée à l'aide d'une couche (4) de dioxyde de silicium déposée sur la couche (3) de siliciures métalliques, de manière que les régions diffusées (8) restent recouvertes par la couche triplée formée, et que l'oxydation de portes est effectuée ensuite.

2. Procédé suivant la revendication 1, caractérisée par les phases opératoires suivantes:

a) dépôt d'une couche de silicium (2) polycristalline d'un second type de conduction sur un substrat (1) en silicium d'un premier type de conduction,

b) dépôt d'une couche métallique formant les siliciures et transformation de la zone proche de la surface de la couche de silicium polycirstallin en une couche (3) de siliciures métalliques,

c) dépôt sur toute la surface d'une couche (4) de dioxyde de silicium,

d) structuration de la couche triplée: couche de $SiO_2$-siliciures métalliques-silicium polycristallin de manière que les régions monocristallines diffusées (8) restent recouvertes,

e) fabrication de l'oxyde de portes (5) par oxydation thermique,

f) formation par attaque chimique de trous de contact (7) jusqu'aux régions diffusées,

g) dépôt sur toute la surface d'une couche de silicium (9) polycristallin non dopée,

h) oxydation locale de la couche de polysilicium (9) non dopée en utilisant un masque de nitrure, à l'exception des régions de portes et des trous de contact jusqu'aux régions diffusées (8).

i) dopage de la couche de polysilicium (9) non dopée avec une substance dopante du deuxième type de conduction,

j) formation des voies conductrices métalliques.

3. Procédés suivant les revendications 1 et/ou 2, caractérisé en ce que la couche de silicium (2) polyristallin dopée est déposée avec une épaisseur de couche d'environ 0,2 μm.

4. Procédé suivant les revendications 1 à 3, caractérisé en ce que comme couche métallique formant un siliciure, une couche de platine, tungstène ou molybdène est déposée, de préférence suivant une épaisseur de couche d'environ 0,1 μm, et passe dans la couche (3) de siliciures métalliques.

5. Procédé suivant la revendication 4, caractérisé en ce que la formation de couche de siliciures est réalisée dans une atmosphère de gaz inerte à une température allant de 600 à 800 °C.

6. Procédé suivant les revendications 1 à 5, caractérisé en ce que l'épaisseur de couche de la couche (4) de $SiO_2$ déposée sur la couche (3) de siliciures métalliques est réglée dans une gamme allant de 0,2 à 0,5 μm, de préférence sur 0,3 μm.

7. Procédé suivant l'une des revendications 1 à 6, caractérisé en ce que l'épaisseur d'oxyde de porte (5) est réglée sur 20 à 60 nm.

8. Procédé suivant l'une des revendications 1 à 7, caractérisé en ce qu'après l'attaque chimique du masque de nitrure, une substance dopante du premier type de conduction est implantée pour le réglage de la tension de blocage de l'oxyde de porte.

9. Procédé suivant l'une des revendications 1 à 8, caractérisé en ce que pour le réglage de la tension de blocage des transistors, avant la phase opératoire i), est effectuée, l'implantation d'atomes étrangers constitués de préférence par du bore, du phosphore ou de l'arsenic.

**Claim**

1.   process for the production of low-resistance diffused zones (8), which are to be used as current-supply paths in intergrated MOS-semiconductor, circuits using the silicon gate technology, wherein the film resistance of these zones (8) is reduced by the formation of a superficial metal silicide layer (3), characterised in that the metal silicide layer (3) which has been produced on a doped polysilicon layer (2) prior to the gate oxidation (5), is so structured with the help of a silicon dioxide layer (4) which is applied to the metal silicide layer (3), that the diffused zones (8) remain covered by the triple layer formed, and that the gate oxidation (5) is subsequently carried out.

2. A process as claimed in Claim 1, characterised by the following process steps:

a) deposition of a polycrystalline silicon layer (2) of a second conductivity type on a monocrystalline silicon substrate (1) of a first conductivity type;

b) deposition of a layer of a metal which will form the silicide and conversion of the region of the polycrystalline silicon layer adjacent to the surface, into a metal silicide layer (3);

c) overall deposition of a silicon dioxide layer (4);

d) structuring of the triple layer $SiO_2$-metal silicide-polycrystalline silicon layer, in such manner that the diffused, monocrystalline zones (8) remain covered;

e) production of the gate oxide (5) by thermal oxidation;

f) etching of contact holes (7) to the diffused zones;

g) overall deposition of an undoped polycrystalline silicon layer (9);

h) local oxidation of the undoped polysilicon layer (9) using a nitride mask with the exception of the gate regions and the contact holes to the diffused zones (8);

i) doping of the undoped polysilicon layer (9) by means of a dopant of the second conductivity type;

j) production of metallic conductor paths.

3. A process as claimed in Claim 1 and/or Claim 2, characterised in that the doped polycrystalline silicon layer (2) is deposited in a layer thickness of about 0.2 μm.

4. A process as claimed in Claim 1 to 3, characterised in that a platinum layer, tungsten layer, or molybdenum layer, preferably in a layer thickness of about 0.1 μm, is deposited as a silicide-forming metal layer and converted into the metal silicide layer (3).

5. A process as claimed in Claim 4, characaterised in that the formation of the silicide layer is carried out in an inert gas atmosphere at 600 to 800 °C.

6. A process as claimed in Claim 1 to 5, characterised in that the thickness of the $SiO_2$-layer (4) applied to the metal silicide layer (3) is set in the range of 0.2–0.5 μm, preferably at 0.3 μm.

7. A process as claimed in Claim 1 to 6, characterised in that the gate oxide thickness (5) is set at 20 to 60 nm.

8. A process as claimed in Claim 1 to 7, characterised in that, after the etching of the nitride mask, dopant of the first conductivity type is implanted to set the gate oxide operating voltage.

9. A process as claimed in Claim 1 to 8, characterised in that in order to set the operating voltage of the transistors prior to the process step i), an implantation of alien atoms, preferably of boron, phosphorus or arsenic, is carried out.

**FIG 1**

**FIG 2**

**FIG 3**

**FIG 4**